(19) Europäisches Patentamt
European Patent Office
Office européen des brevets

(11) **EP 3 839 833 A1**

(12) **EUROPEAN PATENT APPLICATION**

(43) Date of publication:
**23.06.2021 Bulletin 2021/25**

(51) Int Cl.:
***G06N 3/063*** (2006.01)  ***G06N 3/04*** (2006.01)
***G06N 3/08*** (2006.01)

(21) Application number: **19216510.8**

(22) Date of filing: **16.12.2019**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
**KH MA MD TN**

(71) Applicant: **ams International AG**
**8645 Jona (CH)**

(72) Inventor: **Michel, Fridolin**
**8640 Rapperswil (CH)**

(74) Representative: **Epping - Hermann - Fischer**
**Patentanwaltsgesellschaft mbH**
**Schloßschmidstraße 5**
**80639 München (DE)**

(54) **NEURAL AMPLIFIER, NEURAL NETWORK AND SENSOR DEVICE**

(57) A differential switched capacitor neural amplifier comprises a sampling stage (SMP) with a plurality of differential inputs for receiving a plurality of input voltages and with at least one pair of digitally adjustable charge stores for sampling the plurality of input voltages, a summation stage (SM) for summing up charges resulting from the sampled plurality of input voltages in order to generate a summation signal, the summation stage (SM) being connected downstream to the sampling stage (SMP), and a buffer and activation stage (ACB) that is configured to apply an activation function and to generate a buffered output voltage at a differential output, based on the summation signal.

**Fig 3**

**Description**

The present disclosure relates to a differential switched capacitor neural amplifier, for instance for usage in an analog artificial neural network, to an analog artificial neural network with one or more of such neural amplifiers and to a sensor device with such neural network.

A neural network is a cascade of neuron layers that are interconnected. An artificial neural network (simply referred to as a neural network herein) is a computing system used in machine learning. The neural network can be based on layers of connected nodes referred to as neurons, which can loosely model neurons in a biological brain. The basic element of a neural network is the single neuron which calculates the weighted sum of its inputs. It has been shown that any or almost any function can be implemented via a neural network by properly adjusting the individual neuron weights, also referred to as training.

Each layer can have multiple neurons. Neurons between different layers are connected via connections, which correspond to synapses in a biological brain. A neuron in a first layer can transmit a signal to another neuron in another layer via a connection between those two neurons. The signal transmitted on a connection can be a real number. The other neuron of the other layer can process the received signal (i.e., the real number), and then transmit the processed signal to additional neurons. The output of each neuron can be computed by some non-linear function based on inputs of that neuron.

Basically, a neuron performs a number of multiply accumulate, MAC, operations on its inputs. Consequently, neural networks with a large number of neurons and high interconnectivity need to perform a vast number of MAC operations. As by today neural networks are mostly implemented in digital and since a digital MAC operation is computationally expensive a considerable amount of computing power is required. Hence, conventional neural networks are typically not implemented on battery powered edge devices.

In contrast, conventional analog neuron implementations claim to be more power efficient but require high implementation effort that increases exponentially with the number of inputs of the respective neuron. Furthermore, an accuracy of the MAC operations of the analog neuron has influence on the overall accuracy and precision of the analog neural network, in particular with respect to an increasing number of neurons and/or number of interconnections between the neurons. Conventional analog neurons have deficiencies in this respect.

An objective to be achieved is to provide an improved concept for analog neural networks with improved performance and/or flexibility.

This objective is achieved with the subject matter of the independent claims. Embodiments and developments of the improved concept are defined in the dependent claims.

The improved concept is based on the insight that two basic functions of an analog neuron have to be efficiently implemented that have different implementation requirements, namely the weighting of several input signals and their summation. For example, while summing signals in the current domain can be easily achieved, weighting current signals requires a much larger implementation effort that scales with the number of weights.

The improved concept therefore proposes an analog neural amplifier with two basic stages that each can be implemented efficiently and with a high precision. A first stage is a sampling stage with a plurality of inputs for receiving a plurality of input voltages and with one or more digitally adjustable charge stores for sampling the plurality of input voltages. For example, each of the digitally adjustable charge stores is adjusted based on the respective weight for the input voltage that the charge store is sampling. Preferably, the input voltages are provided as differential voltages, such that the plurality of inputs are differential inputs. A second stage is a summation stage for summing up charges resulting from the sampled plurality of input voltages in order to generate a summation signal. In particular, the summation stage is connected downstream to the sampling stage. For example, the summation stage comprises at least one pair of charge stores for storing the summed up charges.

Further stages of the analog neural amplifier may comprise a buffer and activation stage which can apply an activation function and generate a buffered output voltage at the differential output, based on the summation signal, respectively the summed up charges.

Using a switched capacitor technology for the analog neural amplifier allows to have an efficient interface between the different stages of the amplifier, which can be implemented with reasonable effort, and still ensures a high precision operation. Using a differential signal approach further improves the accuracy of the neural amplifier, for example by reducing effects of charge injection that may be detrimental for the accuracy of an overall calculation result.

The improved concept provides an implementation for a differential switched capacitor neural amplifier that, for example, is suitable for usage in an analog artificial neural network. The neural amplifier comprises the sampling stage with a plurality of differential inputs for receiving a plurality of input voltages and with at least one pair of digitally adjustable charge stores for sampling the plurality of input voltages. The neural amplifier further comprises the summation stage for summing up charges resulting from the sampled plurality of input voltages in order to generate a summation signal. The summation stage is connected downstream to the sampling stage. A buffer and activation stage is configured to apply an activation function and to generate a buffered output voltage at a differential output, based on the summation signal. As mentioned above, each digitally adjustable charge store may be adjusted according to a respective weight that is to be implemented for the input voltage to be sampled.

There are several implementations with respect to counterparting differential inputs and pairs of digitally adjustable charge stores and their respective interconnections. For example, in some implementations a number of the differential inputs corresponds to a number of pairs of the digitally adjustable charge stores. In other words, for each one of the differential inputs, a specific pair of digitally adjustable charge stores is provided. This means that all differential input voltages can be sampled on the respective associated pair of charge stores at the same time, allowing faster operation of the summation signal and consequently the whole neural amplifier. Nevertheless this comes with the effect that an implementation effort of the neural amplifier is increased in terms of area due to the higher number of pairs of charge stores.

In an alternative implementation, the sampling stage comprises at least one multiplexer for selectively connecting the plurality of differential inputs to the at least one pair of digitally adjustable charge stores. Accordingly, a time multiplex can be applied for sampling the differential input voltages on the digitally adjustable charge stores, i.e. reusing the same pair of adjustable charge stores for several different input voltages.

For example, a number of the multiplexers corresponds to the number of pairs of the digitally adjustable charge stores. Hence, for example, a single pair of digitally adjustable charge stores could be provided together with a single multiplexer connecting all of the differential inputs to the pair of charge stores. This would result in a reduced effort for implementing the digitally adjustable charge stores with a reasonable effort for the multiplexer. Still, due to the time multiplex, processing times may increase.

However, if the number of pairs of digitally adjustable charge stores and associated multiplexers increases, processing time can be reduced with slightly increased effort for the charge stores, allowing counterbalancing effort and speed.

The summation stage according to various implementations, for example comprises a differential integrating amplifier with a pair of integrating charge stores in a differential feedback path of the integrating amplifier. For example, the integrating amplifier is implemented as an operational transconductance amplifier, OTA. A differential integrating amplifier allows effective transfer of the stored charges in the sampling stage to the summation stage and integrating them, i.e. summing them up, on the integrating charge stores.

For example, in some of such implementations the summation stage further comprises a pair of double sampling charge stores switchably connected downstream the integrating amplifier. In such implementation the neural amplifier is e.g. configured to sample a zero input signal on the pair of double sampling charge stores during a first double sampling phase, e.g. by setting the at least one pair of digitally adjustable charge stores to a zero value, and to provide the charges resulting from the sampled zero input signal to the buffer and activation stage together with charges stored on the pair of integrating charge stores.

Hence, for example a neuron signal summation is preceded by a zero input signal summation, which may be achieved by adjusting the adjustable charge stores such that they do not sample the respective input voltage but e.g. a zero voltage or a common mode voltage. In this way an offset of the sampling stage and the integrating amplifier can be extracted and subtracted during a final charge transfer to the buffer and activation stage, i.e. implementing a correlated double sampling scheme.

For example, in some other of such implementations with a differential integrating amplifier, the neural amplifier further comprises chopping circuitry within and before the summation stage that can reduce charge injection errors resulting from residual errors of various components.

For example, the neural amplifier further comprises for each of the at least one multiplexers, a first differential chopping block coupled between an output of the respective multiplexer and the connected pair of charge stores. The neural amplifier further comprises a second and a third differential chopping block, wherein the second differential chopping block couples a first end of the feedback path of the integrating amplifier to an input side of the integrating amplifier, while the third chopping block couples a second end of the feedback path to an output side of the integrating amplifier. Preferably the second and the third chopping block are controlled in a coordinated fashion. Also the first differential chopping block for each of the multiplexers may be controlled in a coordinated fashion with the second and third chopping blocks. For example, each chopping block can switch between a direct and a crossover connection of the differential signal lines. Chopping may cancel out any residual offsets from all input sampling switches, allowing for a nearly arbitrary number of inputs of the neural amplifier.

In some implementations the differential integrating amplifier of the summation stage comprises switching circuitry for selectively charging the pair of integrating charge stores with the integrating amplifier input offset voltage plus the input offset of the buffer and activation stage. For example, the switching circuitry allows for selectively charging a pair of integrating charge stores with a first offset voltage at the input side of the integrating amplifier and a second offset voltage at an input side of the buffer and activation stage. For example, such implementation allows that during a summation an offset of the integrating amplifier at the output side of the integrating amplifier is removed and an offset of the buffer and activation stage is applied to compensate the offset of the buffer and activation stage.

For example, the first and the second offset voltage are sampled on the integrating charge stores during a time period at which no summation takes place and only the respective offset voltages are present resulting from respective settings of the switching circuitry. During an actual summation of the charges of the sampling stage, the sampled offset voltages cancel out with these offset voltages also being present during such a summation phase.

In some implementations the buffer and activation stage comprise a buffer stage with a differential capacitive amplifier with a further pair of charge stores and a further differential feedback path of the capacitive amplifier. Such an implementation, for example, allows for an easy transfer of the charges summed up and stored on the integrating charge stores to the buffer stage in order to allow the generation of the buffered output voltage. Similar to the summation stage, also the differential capacitive amplifier of the buffer stage may be implemented as an OTA.

In some of such implementations, the activation function of the buffer and activation stage may be implemented by limiting a supply voltage of the capacitive amplifier and/or the buffer stage. For example, a clipping function may be implemented in this way as the activation function, limiting the output voltage between positive and negative supply voltages, respectively.

In some alternative implementations, the buffer and activation stage further comprises a clipping stage connected upstream or downstream of the buffer stage, and wherein the activation function is implemented by the clipping stage. This, for example, allows the implementation of more sophisticated clipping functions.

For example, the clipping stage is connected downstream of the buffer stage and is configured to compare a differential voltage at an output of the buffer stage to a differential reference voltage. The clipping stage may output the differential reference voltage at the differential output if the differential voltage at the output of the buffer stage exceeds the differential reference voltage either in a positive or a negative direction. Otherwise, the clipping stage outputs at the differential output, the differential voltage at the output of the buffer stage, e.g. without clipping.

In various implementations of the neural amplifier, each digitally adjustable charge store of the at least one pair of digitally adjustable charge stores may comprise a first and a second charging terminal and a plurality of weighted charge stores, each having a first end connected to the first charging terminal and a second end selectively connected to the second charging terminal or to a common mode terminal, depending on a digital adjustment word. For example, the digital adjustment word corresponds to the desired weight to be applied on the respective input voltage.

For example, the plurality of weighted charge stores are binary weighted such that neighboring charge stores differ in their capacity by a factor of two. In other implementations, all charge stores may have the same weight, respectively capacity, thus implementing e.g. a linear weighting scheme. Furthermore, linear and binary weighting may be combined. Preferably, the adjustable charge stores of a pair are made corresponding to each other, in particular are made nominally identical, and are controlled commonly to have the same capacitance during sampling.

In the various implementations, the neural amplifier may further comprise a control circuit for controlling a switched capacitor function of the neural amplifier and/or for adjusting the at least one pair of digitally adjustable charge stores. This may include controlling of multiplexers and/or chopper stages, if applicable.

A neural amplifier according to one of the implementations above may be used in an analog artificial neural network, e.g. a recurrent neural network. Such a neural network may comprise a plurality of such neural amplifiers, wherein the differential output of at least one of the neural amplifiers is connected to one of the differential inputs of the same or another one of the neural amplifiers. The neural network may comprise several layers, e.g. an input layer, an output layer and one or more hidden layers that each comprise one or more of the neural amplifiers as described above. The analog implementation of the neural network allows an efficient implementation together with e.g. analog sensors due to similar manufacturing processes. Power consumption is reduced compared to conventional digital neural networks as for example no analog-to-digital converters and no neural network processors are needed.

Accordingly, the improved concept also proposes a sensor device comprising one or more sensors, e.g. analog sensors, and an analog artificial neural network as described before, wherein output signals of the one or more sensors are provided to at least one of the neural amplifiers.

Training of the neural network can be performed online, i.e. during operation of the network, offline, e.g. by simulating the neural network in order to determine the respective weight factors, or even a combination of an offline training with a subsequent online calibration, for example. Other implementations are not excluded by these examples.

The improved concept will be described in more detail below for several embodiments with reference to the drawings. Identical reference numerals designate signals, elements or components with identical functions. If signals, elements or components correspond to one another in function, a description of them will not necessarily be repeated in each of the following figures.

In the drawings:

Figure 1          shows an example implementation of an analog neural amplifier;

Figure 2          shows an example implementation of a neural network;

Figure 3          shows an example implementation of a neural amplifier according to the improved concept;

Figure 4          shows an example diagram of controls signals that can be applied to the neural amplifier according to Figure 3;

Figure 5          shows an example implementation of a digitally adjustable charge store;

Figure 6          shows an example implementation of a sampling stage of a neural amplifier;

Figure 7          shows an example diagram of control signals that can be applied to a neural amplifier implemented according to Figure 6;

Figure 8          shows a further example implementation of a neural amplifier according to the improved concept;

Figure 9          shows an example diagram of control signals that can be applied to the neural amplifier according to Figure 8;

Figure 10         shows a further example implementation of a neural amplifier according to the improved concept;

Figure 11         shows an example diagram of control signals that can be applied to the neural amplifier according to Figure 10;

Figure 12         shows a further example implementation of a neural amplifier according to the improved concept;

Figure 13         shows an example diagram of control signals that can be applied to the neural amplifier according to Figure 10;

Figure 14A to 14D   show several example phases to be applied to a neural amplifier according to the improved concept;

Figure 15         shows an example implementation of an operational transconductance amplifier usable in a neural amplifier;

Figure 16         shows an example implementation of a clipping stage usable in a neural amplifier;

Figure 17         shows an example diagram of control signals that can be applied to the clipping stage according to Figure 14; and

Figure 18         shows an example implementation of a sensor device with an analog artificial neural network.

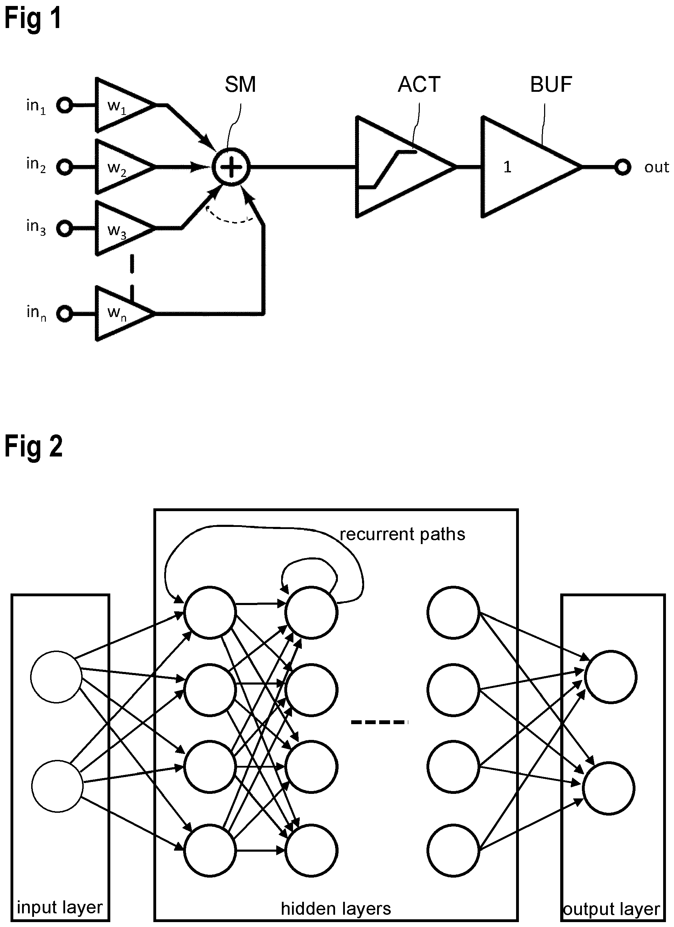

Figure 1 shows an example implementation of an analog neural amplifier with a plurality of inputs $in_1$, $in_2$, $in_3$, ..., $in_n$ being connected to a corresponding number of weighting elements $w_1$, $w_2$, $w_3$, ..., $w_n$. The outputs of the weighting elements are connected to inputs of a summation stage for providing a summation signal. Basically, the summation stage together with the weighting elements performs a number of multiply accumulate, MAC, operations on the plurality of inputs $in_1$, $in_2$, $in_3$, ..., $in_n$. The summation signal at the output of the summation stage SM is provided to an activation stage ACT for applying an activation function, e.g. a clipping function or the like, to the summation signal. An output of the activation stage ACT is provided to a buffer stage BUF for providing a buffered output signal, e.g. output voltage at an output OUT of the neural amplifier. Figure 1 describes the basic function of a neural amplifier that can be used, for example, in an analog neural network.

For example, a neural network is a cascade of neuron layers that are interconnected. Figure 2 shows an example implementation of such a neural network with a plurality of neurons distributed over several layers, and represented by circles in Figure 2. For example, the neural network comprises an input layer, an output layer and several hidden layers. An output of each neuron may be connected to one or more other neurons of the neural network, indicated by arrows originating from the respective neurons. Consequently, each neuron may be connected to the output of one or more other neurons or even its own output, thereby establishing a recurrent path.

As mentioned before, neural networks with a large number of neurons and high interconnectivity need to perform a vast number of MAC operations. Today neural networks are mostly implemented digitally, thus requiring a considerable amount of computing power. In contrast, an analog MAC operation is in principle a one-shot operation. Whereas values in the digital domain are represented by a number of bits in analog, only a single storage unit is required to hold the value independent of the resolution. Hence, there is increasing effort to shift MAC operations into the analog domain, opening the field of analog neural networks. Analog neural networks do not rely on sub-nanometer technology nodes to achieve competitive performance. Speed is achieved by levering analog properties which do not scale well with technology. This supports implementation in older low cost and analog optimized technologies. Analog neural networks are therefore an attractive option for co-integration with, for example, analog sensor readout circuits.

Implementing an analog neuron for a recurrent neural network requires an amplifier that can sum its inputs while holding the previous value and driving other neuron inputs at the same time. Performance can even be increased by implementing a low offset and gain error, which prevents accumulation of errors over different cycles. For example in recurrent neural networks, results are fed back to prior neurons by respective recurrent paths, as indicated in Figure 2.

In the following, several example implementations of an analog neural amplifier according to the improved concept will be described that are suitable for an efficient implementation of an analog neural network with or without recurrent paths. The improved concept enables an analog neuron implementation with differential signal processing and a switched capacitor approach, which reduces effects of charge injection, thus improving the position of an analog neuron and consequently an analog neural network implemented with such neurons. Performance may be further improved by including a switch charge injection and/or amplifier offset cancellation scheme. In summary, a high number of neurons can be connected to a single summing node even in a recurrent operation without significant offset accumulation. Furthermore, by making offset errors and gain errors negligible, corresponding drifts over PVT are not a concern. Consequently periodic retraining or calibration is not necessary.

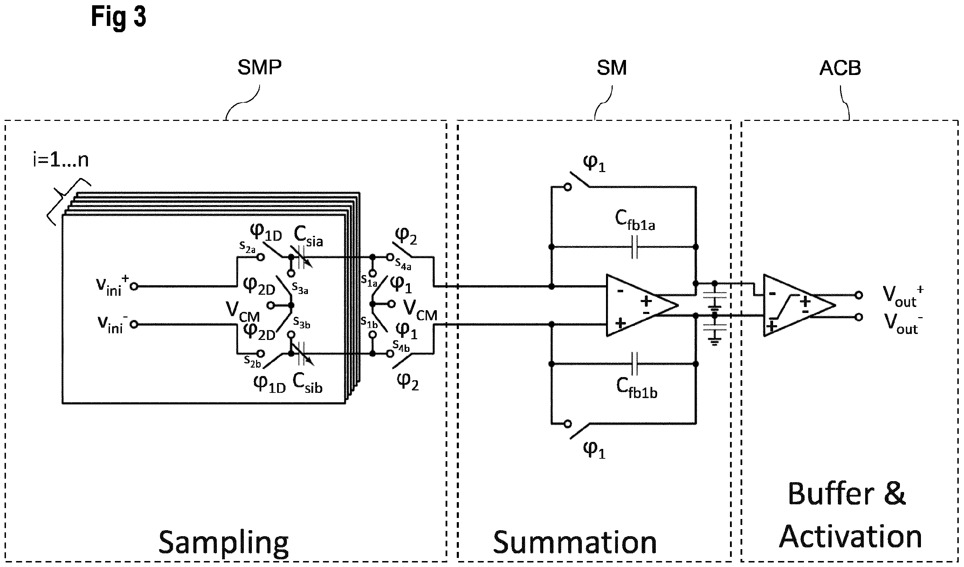

Figure 3 shows an example implementation of an analog neural amplifier with a sampling stage SMP, a summation stage SM and a buffer and activation stage ACB. As indicated in conjunction with Figure 1, Figure 3 implements a sampling stage with n inputs with n parallel sampling structures, from which only an example structure is shown for reasons of a better overview. The sampling structure has a differential input pair $V_{ini}^+$, $V_{ini}^-$, representing the input i of n possible inputs. Each structure further comprises a pair of digitally adjustable charge stores $C_{sia}$, $C_{sib}$ that have their first terminal connected to the differential signal input $V_{ini}^+$, $V_{ini}^-$ via respective switches $S_{2a}$, $S_{2b}$. The first terminal of the charge stores $C_{sia}$, $C_{siab}$ is also coupled to a common mode terminal $V_{CM}$ via respective switches $S_{3a}$, $S_{3b}$.

Second terminals of the charge stores $C_{sia}$, $C_{sib}$ are coupled to the common mode terminal $V_{CM}$ via further respective switches $S_{1a}$, $S_{1b}$, and further to the summation stage SM via respective switches $S_{4a}$, $S_{4b}$. While the pair of charge stores $C_{sia}$, $C_{sib}$ and the corresponding switches $S_{2a}$, $S_{2b}$, $S_{3a}$, $S_{3b}$ are present multiple times in the sampling stage SMP, i.e. n times, switches $S_{1a}$, $S_{1b}$, $S_{4a}$, $S_{4b}$ may be common to all such sampling structures and provided only once, however, without excluding the possibility of a multiple presence.

The charges stores $C_{sia}$, $C_{sib}$ are digitally adjustable, in particular for setting a respective weight for the associated input $V_{ini}^+$, $V_{ini}^-$, at which a differential input voltage can be received.

The summation stage SM for example comprises an amplifier, for example an operational transconductance amplifier, OTA, with a pair of integrating charge stores $C_{fb1a}$, $C_{fb1b}$ in a feedback path of the integrating amplifier. Respective switches are connected in parallel to the integrating charge stores $C_{fb1a}$, $C_{fb1b}$ for resetting them.

Downstream to the summation stage SM the buffer and activation stage ACB is connected that is configured to apply an activation function and to generate a buffered output voltage $V_{out}^+$, $V_{out}^-$ at the differential output, based on a summation signal generated in a summation stage SM.

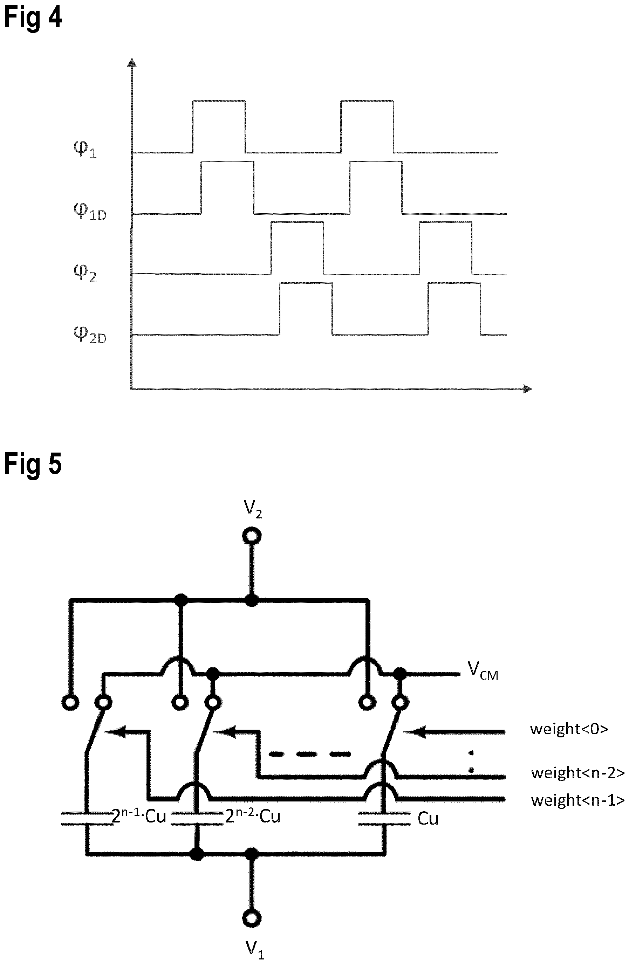

Figure 4 shows an example diagram of control signals that can be applied to the neural amplifier according to Figure 3. In particular, Figure 4 shows switch control signals $\varphi_1$, $\varphi_{1D}$, $\varphi_2$ and $\varphi_{2D}$. For example, during the times where both $\varphi_1$ and $\varphi_{1D}$, which is a slightly delayed version of $\varphi_1$, are high, the respective switches controlled by these signals are closed such that the adjustable charge stores are each connected between the respective input terminal $V_{ini}^+$, respectively $V_{ini}^-$ and the common mode terminal $V_{CM}$ via switches $S_{1a}$, $S_{1b}$. Furthermore, the integrating charge stores $C_{fb1a}$ and $C_{fb1b}$ are reset.

During the high times of switching signals $\varphi_2$ and slightly delayed $\varphi_{2D}$ the respective first terminals of the adjustable charge stores are connected to the common mode terminal $V_{CM}$ while the second terminals are connected to the summation stage via switches $S_{4a}$, $S_{4b}$. This results in the summation stage summing up the charges resulting from the sampled plurality of input voltages on the respective pairs of adjustable charge stores in order to generate the summation signal. The differential approach reduces the effects of charge inaction resulting from the different switches.

Figure 5 shows an example implementation of the digitally adjustable charge store that, for example, can be used in the various sampling structures of the sampling stage SMP. For example, the charge store comprises a first charging terminal $V_1$ and a second charging terminal $V_2$ and a plurality of weighted charge stores, each having a first end connected to the first charging terminal $V_1$ and a second end selectively connected to the second charging terminal $V_2$ or to the common mode terminal $V_{CM}$, depending on a digital adjustment word. In the example of Figure 5, the charge stores are binary weighted starting with a first charge store having a capacitance value $Cu$ and an $n^{th}$ charge store having a capacitance value $2^{n-1} \cdot Cu$. Respective switches are controlled by the digital adjustment word comprising the single bits weight<0>, ..., weight<n-2>, weight<n-1>. Other weighting schemes instead of a binary weighting scheme can be used as well.

The implementation of Figure 5 may be called a sample capacitor digital-to-analog converter, DAC, as the digital adjustment word is converted to an analog capacitance value, in particular with the binary weighting scheme.

Referring back to Figure 3, if all n neuron inputs are to be sampled and summed in one shot, the total number of individual routing lines would be $n*n_{adj}$ with $n_{adj}$ denoting the number of bits of the adjustment word of the adjustable charge store.

In practice, routing complexity increases with the number of differential inputs and with the number of the weight resolution $n_{adj}$. In order to obtain a routing complexity of O(n), multiplexing of the differential neural inputs may be performed, such that for example different differential input voltages are sampled and summed in subsequent phases. This also means that the pairs of digitally adjustable charge stores or capacitor DACs are reused for several differential inputs.

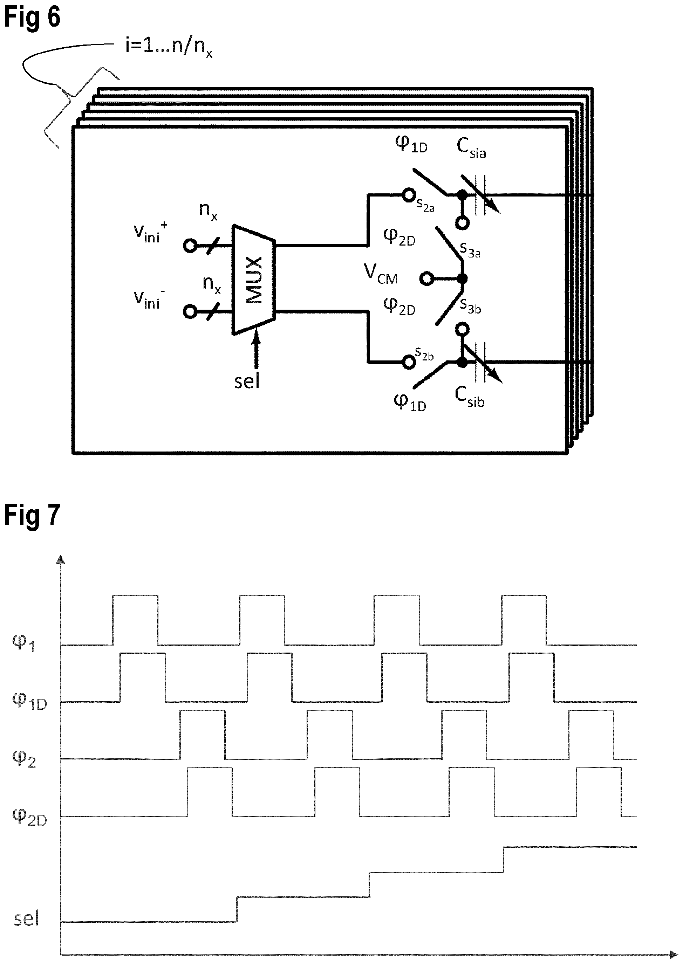

Referring now to Figure 6, an example implementation of a part of the sampling stage SMP is shown, in particular a different implementation of the parallel sampling structures at the input side of the sampling stage SMP. Generally, this example implementation is based on the implementation of Figure 3, but at least one multiplexer MUX is introduced between several of the differential inputs and an associated charge store pair $C_{sia}$, $C_{sib}$.

In this example implementation, $n_x$ inputs are multiplexed to one pair of adjustable charge stores $C_{sia}$, $C_{sib}$, thereby reducing the routing complexity. It should be noted that the number of parallel sampling structures is therefore reduced to $n/n_x$ compared to n sampling structures in Figure 3. For instance, if for $n_{adj}$ of weight resolution a multiplex factor $n_x$ is set $n_x = n_{adj}$, the routing overhead increases linearly with $n_{adj}$.

Referring now to Figure 7, an example diagram of control signals that can be applied to a neural amplifier in accordance with Figure 6 is shown. For either explanation, it is generally referred to Figure 4, which expressed the basic scheme between the various switch settings controlled by signals $\varphi_1$, $\varphi_{1D}$, $\varphi_2$ and $(\varphi_{2D}$. Now for Figure 7, the selection signal SEL controls the multiplexer MUX to subsequently connect several inputs to the adjustable charge stores. For example, $n_x$ is chosen to be 4 in this example, without loss of generalization.

Consequently, routing complexity is traded against conversion time. Due to the multiphase conversion the summation signal provided by the summation stage, and therefore also the buffered output voltage is not available for driving the output respectively differential inputs of other neuron amplifiers during consecutive cycles. Therefore, the summation signal of the summation stage is sampled by the buffer and activation stage ACB after the last summing phase. The buffered output voltage can then drive the differential inputs of other neural amplifiers or one of its own differential inputs during a next recurrent cycle.

The differential structure significantly reduces charging action errors even for a high number of input connections to the neural amplifier. However, residual charge injection errors may remain, e.g. originating from offset errors that may sum up to a non-negligible amount, which may be further accumulated in a recurrent operation mode, depending on the number of differential inputs of a single neural amplifier and the number of neurons employed in the neural network.

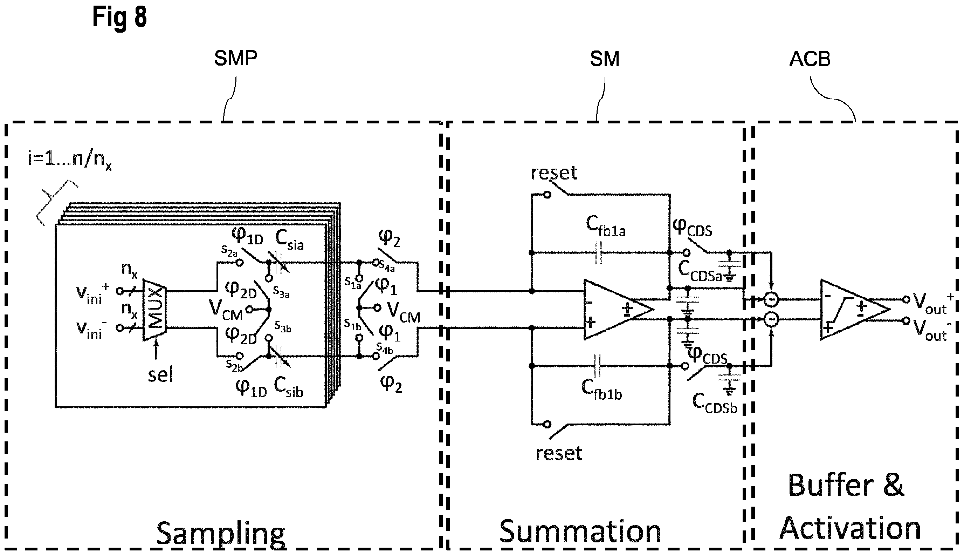

Referring now to Figure 8, a further development of the improved concept for a neural amplifier is shown that is based on the implementations of Figure 3 and Figure 6. In this example implementation, in order to eliminate offset by the input sampler and summation amplifier correlated double sampling, CDS, is employed. To this end, the summation stage SM further comprises a pair of double sampling charge stores $C_{CDSa}$, $C_{CDSb}$ that is connected to the output side of the integrating amplifier via a pair of the respective switches controlled by a double sampling control signal $\varphi_{CDS}$. Furthermore, the pair of double sampling charge stores $C_{CDSa}$, $C_{CDSb}$ is connected to an input side of the buffer and activation stage via respective difference elements in order to subtract the charges stored on the double sampling charge stores $C_{CDSa}$, $C_{CDSb}$ from the charges stored on the integrating charge stores $C_{fb1a}$ and $C_{fb1b}$.

During operation, in the neural amplifier this can be implemented by deselecting all units of the capacitor DACs, e.g. by connecting them to the common mode terminal $V_{CM}$, thus effectively sampling a zero signal. In other words, a zero weight may be selected for the adjustable charge stores during this phase. The corresponding neural amplifier output is thus equivalent to its output offset and can be subtracted from the actual neural amplifier output with neural input signals. However, because the neural amplifier output is analog this operation cannot be realized in digital and will be performed during the charge transfer to the buffer. This requires the additional double sampling charge stores $C_{CDSa}$, $C_{CDSb}$ at the summation amplifier output to hold the zero input signal summation outputs during the consecutive neural input conversion.

However, one issue with correlated double sampling is the reduction in conversion rate by 2. Moreover, subtraction of the offset in analog may introduce additional error sources.

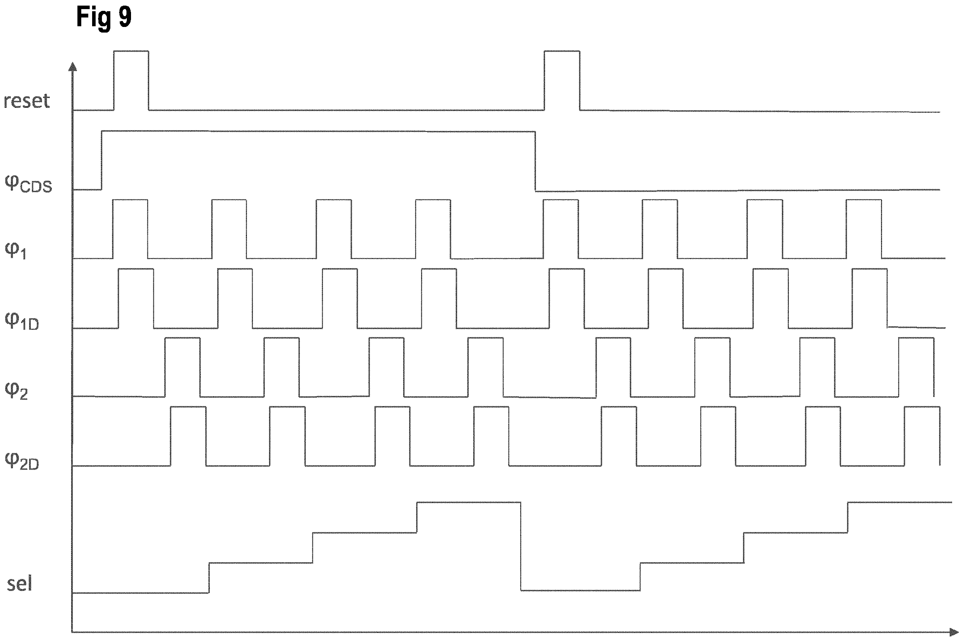

Referring now to Figure 9, an example diagram of control signals that can be applied to the neural amplifier according to Figure 8 is shown.

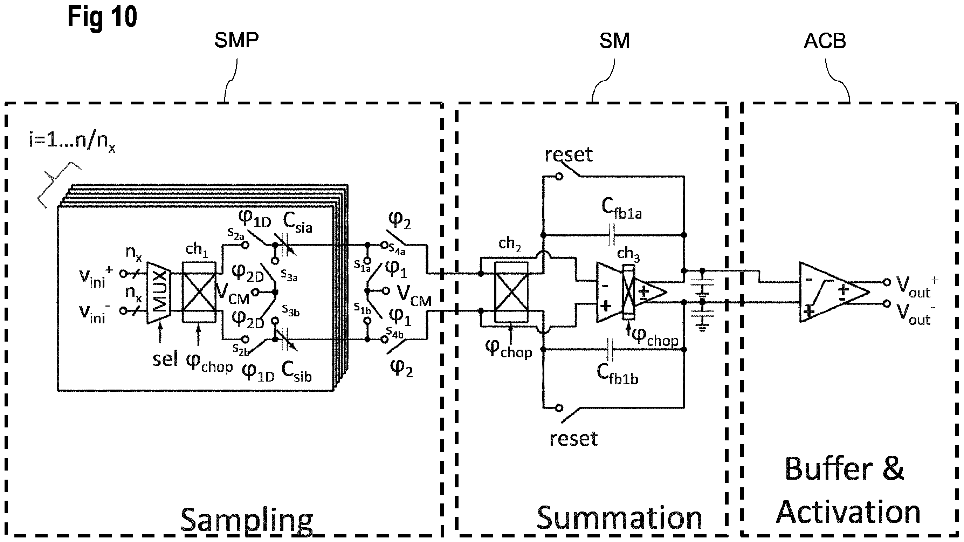

Referring now to Figure 10, a further development of the improved concept for a neural amplifier is shown that is based on the implementations of Figure 3 and Figure 6. In addition to the previous implementations, a chopping scheme is added, in particular by including several chopping blocks ch1, ch2 and ch3 in the neural amplifier. Introduction of a chopping (sometimes also referred to as swapping) is possible due to the multi-phase sampling scheme related to the multiplexer.

For example, the first chopping block ch1 is provided in each parallel sampling structure between the multiplexer MUX and the connected pair of adjustable charge stores $C_{sia}$, $C_{sib}$. Furthermore, a second differential chopping block ch2 is implemented in the summation stage SM and couples the first end of the differential feedback path including integrating charge stores $C_{fb1a}$, $C_{fb1b}$ to an input side of the integrating amplifier. Similarly, a third differential chopping block ch3 couples the second end of the differential feedback path to an output side of the integrating amplifier.

The chopping blocks ch1, ch2, ch3 are controlled by a chopping control signal $\varphi_{chop}$ and have the function of either directly connecting the differential path between its input and output sides or to cross connect the differential paths, which basically corresponds to an inversion of the differential signal. If the chopping phases are distributed equally over the various switching phases, chopping can cancel out any residual offsets from all input sampling switches, allowing for a nearly arbitrary number of differential inputs.

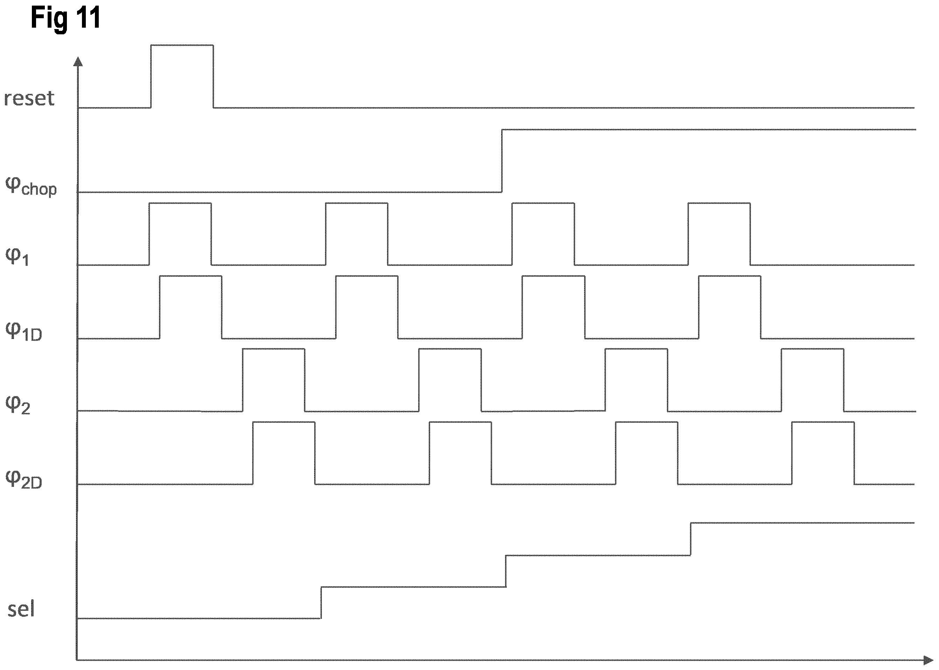

Referring now to Figure 11, an example diagram of control signals that can be applied to the neural amplifier according to Figure 10 is shown. It is again referred to the previous explanations of example diagrams in Figure 4 and Figure 7. For example, in addition to the switching scheme in Figure 7, the chopping signal $\varphi_{chop}$ is zero during the first half of the summation phases such that the offset of the integrating amplifier is accumulated negatively, while during the second half, where $\varphi_{chop}$ is high, the offset of the integrating amplifier is accumulated positively. Hence, the total transferred offset charge on $C_{fb1a}$, $C_{fb1b}$ cancels out each other resulting, at least theoretically, in zero charge. Chopping once only during the summation phases reduces any residual offset introduced by the chopper switches themselves, because their contribution is only added once.

The effectiveness of the chopping scheme is further supported in the context of the neural amplifier if the total equivalent offset, which is the sum of the individual neuron input offsets and the offset of the integrating amplifier is constant and thus independent of the individual neuron input waves controlling the digitally adjustable charge stores in all phases. For example, referring back to Figure 5, if all unit capacitors of the digitally adjustable charge store that are not selected for input sampling, i.e. not being connected to the second terminal $V_2$, are connected to the common mode terminal $V_{CM}$. This keeps the respective unit capacitors active but effectively with zero input. Furthermore, charging injection from all sampling switches $S_{1a}$, $S_{1b}$ is added independently of the different weights, respectively capacitor settings, in the different phases.

Despite chopping, accuracy of the neural amplifier may be further increased, if made necessary by the respective application, for example by the complexity of the neural network. For example, there may be an output offset at an output of the summation stage SM after the last summation phase $\varphi_2$, i.e. the last input voltage has been weighted and summed up, unless the summation stage SM itself is offset compensated.

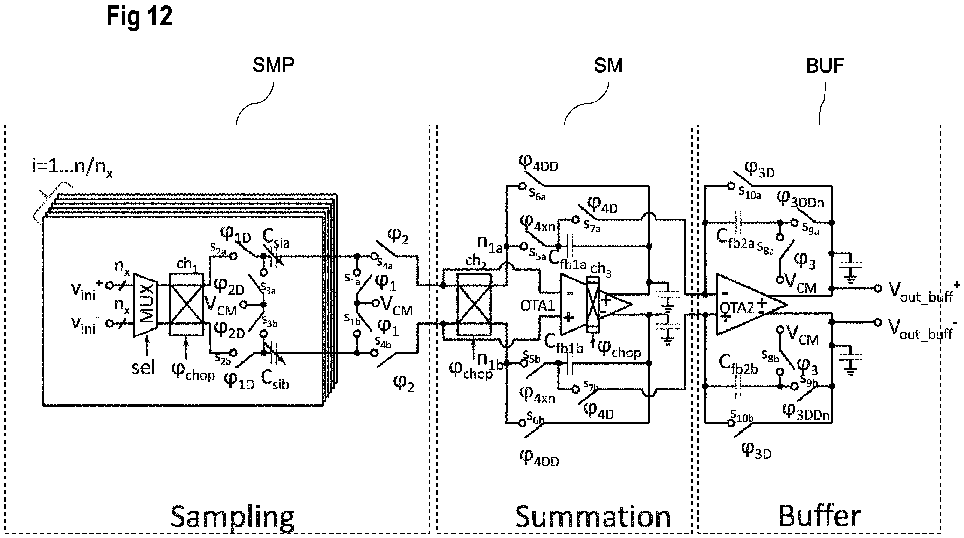

Referring now to Figure 12, this may be accomplished by a further development of the neural amplifier according to the improved concept shown in Figure 12, which is based on the implementation shown in Figure 10. In particular, the sampling stage SMP of Figure 12 fully corresponds to the sampling stage of Figure 10.

In the summation stage SM, a switching pair of switches $S_{5a}$, $S_{5b}$ is introduced which are controlled by switching signal $\varphi_{4xn}$ and connect the differential input of the integrating amplifier OTA1 via the second chopping block ch2 to a first end of integrating charge stores $C_{fb1a}$, $C_{fb1b}$. Switches $S_{6a}$, $S_{6b}$, being controlled by switching signals $\varphi_{4DD}$, correspond to the reset switch of Figure 10. Switches $S_{7a}$, $S_{7b}$, controlled by switching signals $\varphi_{4D}$, couple the first terminal of the integrating charge stores $C_{fb1a}$, $C_{fb1b}$ to a differential input of a capacitive amplifier OTA2 of the buffer stage BUF. An activation stage being part of the buffer and activation stage ACB is not shown here for reasons of a better overview.

The buffer stage BUF comprises a further pair of charge stores $C_{fb2a}$, $C_{fb2b}$ having a first end connected to the differential input of the capacitive amplifier OTA2. A second end of the charge stores $C_{fb2a}$, $C_{fb2b}$ is connected to the common mode terminal $V_{CM}$ via switches $S_{8a}$, $S_{8b}$ controlled by switching signal $\varphi_3$ and to the differential output terminals of the buffer stage BUF via switches $S_{9a}$, $S_{9b}$ controlled by switching signals $\varphi_{3DDn}$. Input and output of the amplifier OTA2 are connected by respective switches $S_{10a}$, $S_{10b}$ being controlled by switching signals $\varphi_{3D}$. A differential buffered output voltage $V_{out\_buf}{}^+$, $V_{out\_buf}{}^-$ is provided at the differential output of the amplifier OTA2.

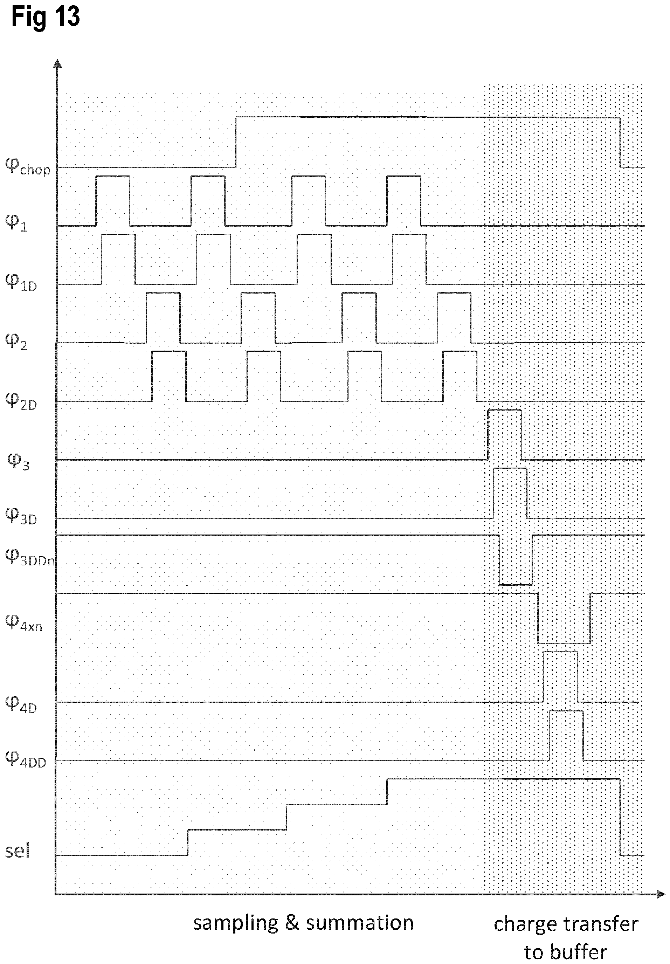

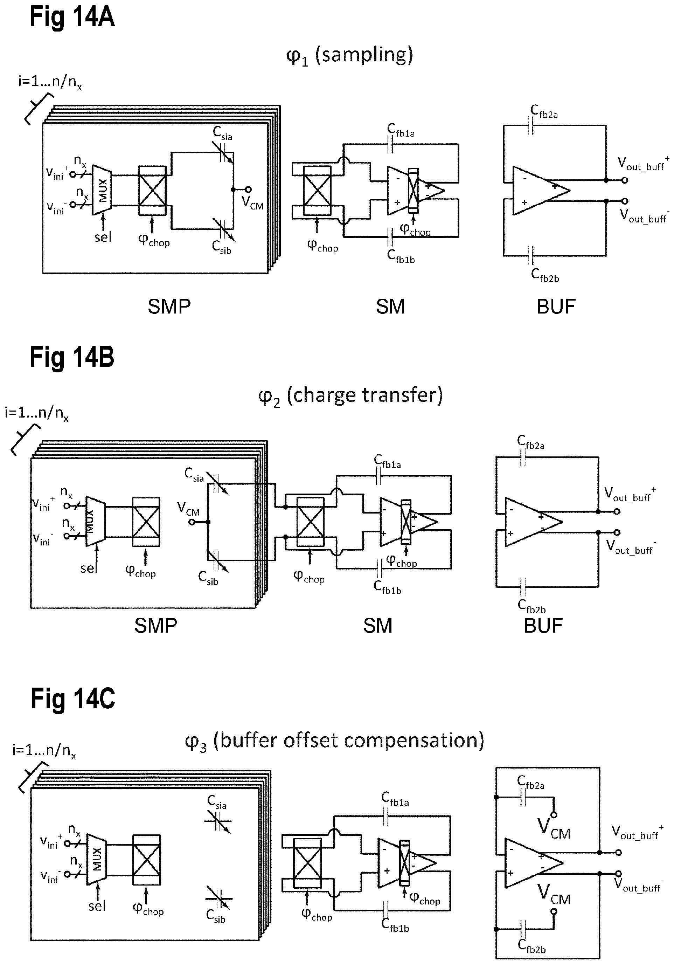

Figure 13 shows an example diagram of control signals that can be applied to the neural amplifier according to Figure 12. For the function of switching signals $\varphi_{chop}$, $\varphi_1$ $\varphi_{1D}$, $\varphi_2$, $\varphi_{2D}$ and sel, it is referred to the respective explanations in conjunction with Figure 7 and Figure 11. With respect to the switching signals $\varphi_3$, $\varphi_{3D}$ and $\varphi_{3DDn}$ it should be noted that $\varphi_{3D}$ is a slightly delayed version of $\varphi_{3D}$, and $\varphi_{3DDn}$ is a further delayed version of $\varphi_3$ that is also negated. Altogether they belong to a buffer offset compensation phase that will be explained in more detail below in conjunction with Figures 14A to 14D.

Similarly, switching signals $\varphi_{4xn}$, $\varphi_{4D}$ and $\varphi_{4DD}$ correspond to a phase for charge transfer to buffer and offset sampling, which will also be explained in more detail below.

Hence, as can be seen from Figure 13, phases $\varphi1$ and $\varphi2$ generally correspond to a sampling and summation phase while switching signals with index 3 and 4 correspond to charge transfer to buffer. It should be further noted that also in the example diagram of Figure 13 $n_x$ has been chosen as 4 for each of explanation without loss of generality of other values for $n_x$.

Referring now to Figures 14A to 14D, the individual phases mentioned before are depicted. The summation phases are split into a sampling phase $\varphi_1$ and a charge transfer phase $\varphi_2$, respectively. For example, Figure 14A shows an actual electrical configuration of the neural amplifier according to Figure 12 with the respective switch settings of $\varphi_1$. Hence, during $\varphi_1$ the input voltages at the differential inputs, e.g. the neuron inputs, are sampled onto the selected unit capacitors of the adjustable charge stores or respective capacitor DAC depending on the corresponding digital adjustment word.

As mentioned before, unselected unit capacitors may be connected to the common mode terminal $V_{CM}$, thus sampling zero signal charge but still introducing charge injection and offset charge of the first integrating amplifier OTA1. This can make the total input offset independent of any weights, respectively adjustment words. Thus, it is cancelled by chopping. As the switching pair $S_{2a}$, $S_{2b}$ is driven by a delayed clock $\varphi1D$, it does not contribute to charge injection offset. Moreover, the first chopping block ch1 does not contribute since it is switched during the non-overlap time of $\varphi_1$ and $\varphi_2$ such that no charges can be transferred from the switching process in the chopping block ch1. With respect to the second chopping block ch2, there may be a charge injection contribution, as charge remains trapped on the internal nodes n1a, n1b, to which the second chopping block ch2 is connected. However, this chopping block ch2 only toggles once during all summation phases, making its contribution small and negligible.

Referring now to Figure 14B, the switching configuration during the charge transfer phase $\varphi_2$ of the neural amplifier of Figure 12 is shown. Accordingly, during $\varphi_2$ the sampling capacitors $C_{sia}$, $C_{sib}$ are discharged and their charge is transferred onto the integrating charge stores $C_{fb1a}$, $C_{fb1b}$. Furthermore, a charge $Q_{off}$ related to the input offset of the integrating amplifier OTA1 is transferred with

$$Q_{off} = C_{s\_total} \cdot V_{off1}.$$

As unselected unit sample capacitors of the adjustable charge store are not kept floating but connected to the common mode terminal $V_{CM}$, a total sample capacitance seen during the charge transfer phase $\varphi_2$ is constant and thus $Q_{off}$ is effectively cancelled by chopping. Furthermore, switches $S_{4a}$, $S_{4b}$ add charge injection which is cancelled by chopping too. Switches $S_{3a}$, $S_{3b}$ do not contribute charge injection due to the delayed switching signal $\varphi_{2D}$.

Referring now to Figure 14C, the electrical configuration of the neural amplifier of Figure 12 is shown during the buffer offset compensation phase $\varphi_3$. In particular, during this phase $\varphi_3$, the differential capacitive amplifier OTA2 with the charge stores $C_{fb2a}$, $C_{fb2b}$ is reset. By further configuring the integrating amplifier OTA1 in unity feedback, it is precharged to the offset voltage of the input side of the buffer stage BUF in order to cancel it at the capacitive amplifier OTA2, respectively its output, after the phase $\varphi3$. As switches $S_{7a}$, $S_{7b}$ are open during this phase $\varphi3$, charge injection from switches $S_{8a}$, $S_{8b}$, $S_{9a}$, $S_{9b}$, $S_{10a}$, $S_{10b}$ is mainly attracted to the lower impedance output of the amplifier OTA2, making residual charge injection small. Moreover, such charge injection is only added once per conversion, further reducing its contribution.

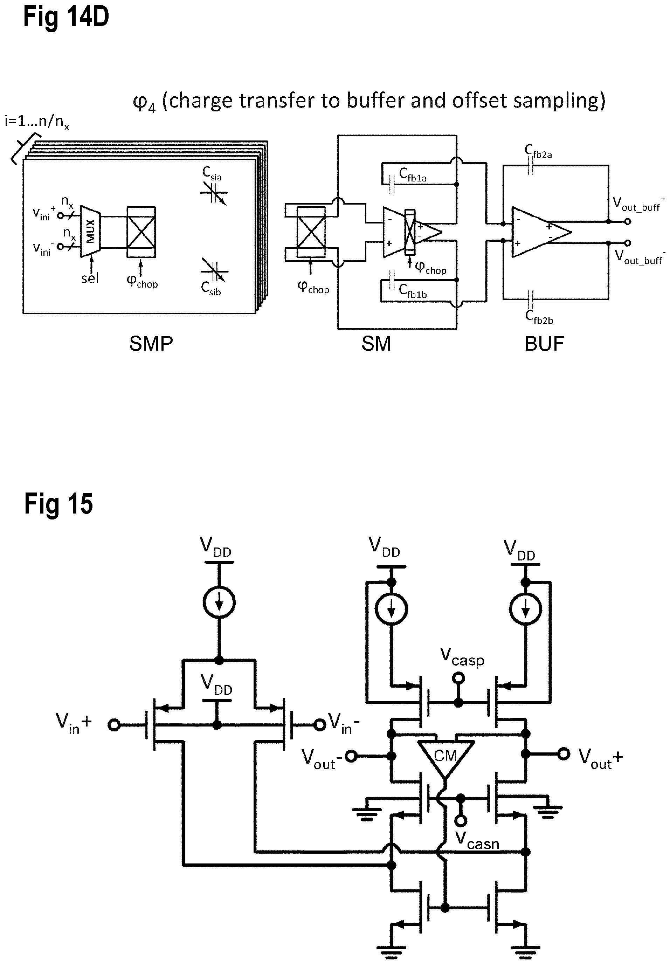

Referring now to Figure 14D, the electrical configuration of the neural amplifier according to Figure 12 during the charge transfer to buffer and offset sampling phase $\varphi_4$ is shown. In particular, during this phase $\varphi_4$, the integrating charge stores $C_{fb1a}$, $C_{fb1b}$ are connected to the input side of the buffer stage, respectively the amplifier OTA2, while the integrating amplifier OTA1 is configured in unity feedback, thus forcing the charge on the integrating charge stores $C_{fb1a}$, $C_{fb1b}$ to be transferred to the charge stores $C_{fb2a}$, $C_{fb2b}$. As the integrating charge stores $C_{fb1a}$, $C_{fb1b}$ have been precharged to the difference between the first offset voltage at the amplifier OTA1 and the second offset voltage of the amplifier OTA2 during the previous phase $\varphi4$, there is no offset charge transferred onto charge stores $C_{fb2a}$, $C_{fb2b}$.

However, there may be some charge injection from switches $S_{5a}$, $S_{5b}$. As these switches $S_{5a}$, $S_{5b}$ always remain at a virtual ground potential, this charge is not signal-dependent and only results in some residual offset, if any. Furthermore, as this charge is only added once per conversion, its impact would still be small. The implementation of the neural amplifier according to Figure 12 avoids any signal swings at the input of both amplifiers OTA1, OTA2, such that there are no signal-dependent charge effects depending on the respective input capacitances of the amplifiers OTA1, OTA2 that would result in any gain error.

Moreover, there is no signal-dependent charge injection leaking to the output, making the gain error solely dependent on an open loop gain of the amplifiers and on the capacitor-matching Of $C_{fb1a}$, $C_{fb1b}$, $C_{fb2a}$, $C_{fb2b}$ and $C_{sia}$, $C_{sib}$.

In various implementations, a contribution of the amplifiers, in particular if implemented as OTAs, can be made small by using a high gain topology, as shown for example in Figure 15, making the gain error insensitive to PVT variations.

Figure 15 shows an example implementation of an operational transconductance amplifier with a differential input stage and a differential output stage with signal outputs connected between a pair of PMOS and NMOS cascode transistors that are driven by respective cascode bias voltages Vcasp, Vcasn respectively that may be generated by an appropriated biasing circuit. The differential output voltage is also used for a common mode feedback circuit CM controlling the current in the output current paths.

As mentioned before, the buffer and activation stage ASB further implements an activation function, which can be a clipping function. Clipping may be accomplished by limiting a supply voltage of the capacitive amplifier OTA2 and/or the buffer stage BUF itself. However, clipping can also be implemented by a dedicated clipping stage.

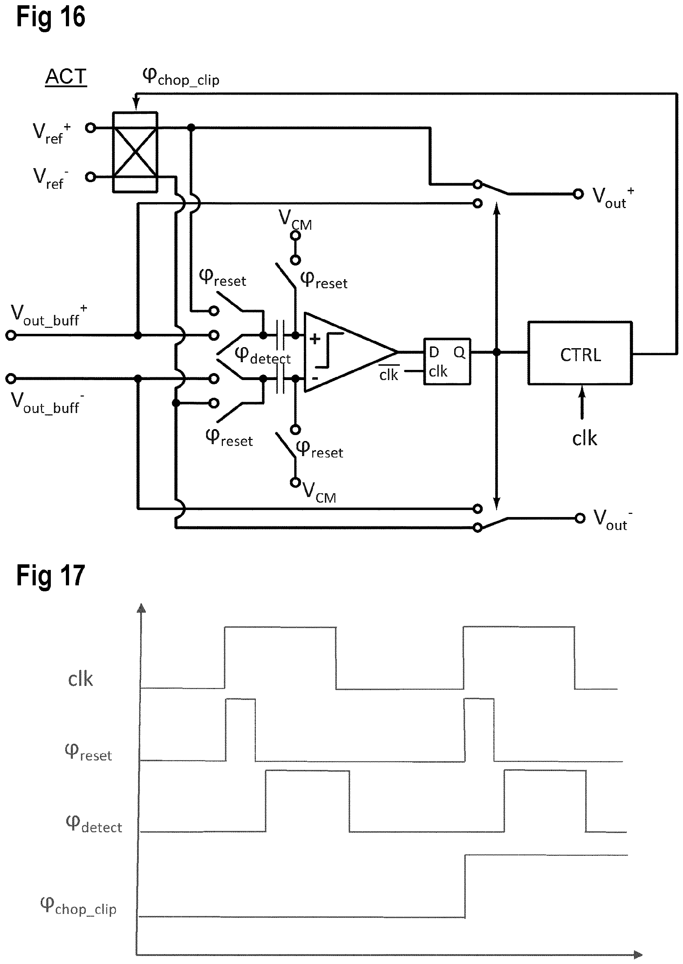

Referring now to Figure 16, an example implementation of such a clipping stage ACT is shown that may be connected to the buffer stage BUF. In Figure 16, clipping is performed by comparing the buffer output voltages $V_{out\_buf}^+$, $V_{out\_buf}^-$ to a predefined reference voltage, in particular a differential voltage, and multiplexing between the buffer voltages $V_{out\_buf}^+$, $V_{out\_buf}^-$ and a reference voltage defining the clipping level. If the buffer output is below the reference, the buffer output is used to drive the output of the neural amplifier, i.e. to provide the buffered output voltage. This voltage can be used to drive other neural amplifiers or, if applicable, an input pair of the same neural amplifier, if a recurrent neural network is implemented.

Otherwise, the reference voltages $V_{ref}^+$, $V_{ref}^-$ will be used as the output voltages $V_{out}^+$, $V_{out}^-$.

As the clipping function must be applied both in positive and negative direction, clipping is performed in two steps, reusing the same comparator and employing a chopping block controlled by a control signal $\varphi_{chop\_clip}$. In particular, first clipping is checked in the positive range by comparing to the positive reference $V_{ref}^+$ while, with reference to the example diagram of Figure 17, $\varphi_{chop\_clip}$ is zero. If clipping is detected, the positive reference is switched to the output $V_{out}^+$, $V_{out}^-$ and the clipping operation has finished. The comparison is performed by the comparator and is subsequently placed flip-flop which allows a clocked operation on the basis of the clock signal clk.

In the case of no positive clipping, the reference is flipped by setting the control signal $\varphi_{chop\_clip}$ to 1 for a comparison against the negative reference using the same comparator. If negative clipping is detected, the negative reference is directed to the output, otherwise the buffer output $V_{out\_buf}^+$, $V_{out\_buf}^-$ is used.

The actual comparison is performed by precharging the capacitances in front of the comparator with the reference voltages and subsequently applying the buffered output voltages $V_{out\_buf}^+$, $V_{out\_buf}^-$ to the sampled voltage in order to detect whether these are higher or lower than the precharged voltages.

As mentioned before, an alternative implementation of clipping is to supply the buffer output stage by the reference. Therefore, the buffer inherently clips the output to the desired levels. This may have the effect that the same clipping levels apply to all neural amplifiers, if the references or all neural amplifiers are supplied by a common voltage regulator, for example. This eliminates clipping threshold shift due to comparator offset. However, supply-based clipping cannot achieve hard clipping but instead is soft and resembles a logistic activation function.

With respect to the various implementations of the neural amplifier described above, a low offset and gain error can be achieved compared to conventional approaches of neural amplifiers, in particular for a high number of neuron inputs by applying, for example, circuit techniques in a fully differential neural amplifier. The reduction in circuit errors results in less concerns with respect to drift. Furthermore, periodic recalibration is not required. Specific implementations with the offset-compensated buffer stage, for example described in conjunction with Figures 12 to 14, improve the applicability of the neural amplifier for neural networks in a recurrent operating mode, where output voltages are fed back to inputs of the same or other neural amplifiers.

Multiple instances of a neural amplifier as described above can be used to form a neural network, as for example described in conjunction with Figure 2. Such neural networks may be used in any circuit requiring weighted or unweighted analog summation of input voltages with high precision while providing parallel driving capability, which for example can be used in the mentioned analog neural networks. For example, analog neural networks are an interesting option for classifying sensor data with hidden or hardly visible patterns.

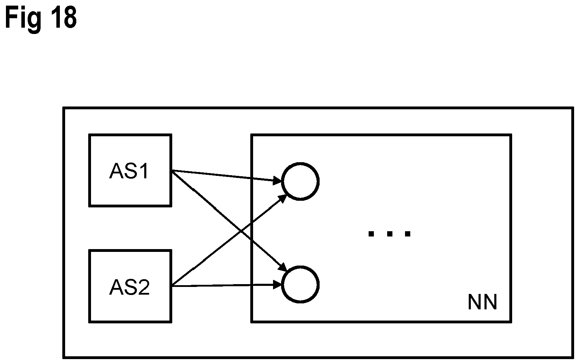

Referring now to Figure 18, an example of a sensor device is shown comprising one or more sensors AS1, AS2 and an analog artificial neural network NN with one or more neural amplifiers as described above. For example, output signals of the one or more sensors AS1, AS2 are provided to differential inputs of the neural amplifiers, indicated as circles as in Figure 2.

Training of the neural network can be performed online, i.e. during operation of the network, offline, e.g. by simulating the neural network in order to determine the respective weight factors, or even a combination of an offline training with a subsequent online calibration, for example. Other implementations are not excluded by these examples.

**Claims**

1. A differential switched capacitor neural amplifier, in particular for usage in an analog artificial neural network, the neural amplifier comprising

   - a sampling stage (SMP) with a plurality of differential inputs for receiving a plurality of input voltages and with at least one pair of digitally adjustable charge stores for sampling the plurality of input voltages;
   - a summation stage (SM) for summing up charges resulting from the sampled plurality of input voltages in order to generate a summation signal, the summation stage (SM) being connected downstream to the sampling stage (SMP); and
   - a buffer and activation stage (ACB) that is configured to apply an activation function and to generate a buffered output voltage at a differential output, based on the summation signal.

2. The neural amplifier according to claim 1, wherein a number of the differential inputs corresponds to a number of pairs of the digitally adjustable charge stores.

3. The neural amplifier according to claim 1, wherein the sampling stage (SMP) comprises at least one multiplexer (MUX) for selectively connecting the plurality of differential inputs to the at least one pair of digitally adjustable charge stores.

4. The neural amplifier according to claim 3, wherein a number of the multiplexers corresponds to a number of pairs of the digitally adjustable charge stores.

5. The neural amplifier according to one of claims 3 or 4, wherein the summation stage (SM) comprises a differential integrating amplifier (OTA1) with a pair of integrating charge stores (Cfb1a, Cfb1b) in a differential feedback path of the integrating amplifier, the neural amplifier further comprising

- for each of the at least one multiplexers a first differential chopping block (ch1) coupled between an output of the respective multiplexer and the connected pair of charge stores;
- a second differential chopping block (ch2) coupling a first end of the feedback path to an input side of the integrating amplifier; and
- a third differential chopping block (ch3) coupling a second end of the feedback path to an output side of the integrating amplifier.

6. The neural amplifier according to claim 5, wherein the differential integrating amplifier of the summation stage (SM) comprises switching circuitry for selectively charging the pair of integrating charge stores with a first offset voltage at the input side of the integrating amplifier and a second offset voltage at an input side of the buffer and activation stage (ACB), in particular such that during a summation an offset of the integrating amplifier at the output side of the integrating amplifier is removed and an offset of the buffer and activation stage (ACB) is applied to compensate the offset of the buffer and activation stage (ACB) .

7. The neural amplifier according to claim 5 or 6, wherein the buffer and activation stage (ACB) comprises a buffer stage (BUF) with a differential capacitive amplifier (OTA2) with a further pair of charge stores (Cfb2a, Cfb2b) in a further differential feedback path of the capacitive amplifier.

8. The neural amplifier according to claim 7, wherein the activation function is implemented by limiting a supply voltage of the capacitive amplifier and/or the buffer stage.

9. The neural amplifier according to claim 7, wherein the buffer and activation stage (ACB) further comprises a clipping stage connected upstream or downstream the buffer stage (BUF), and wherein the activation function is implemented by the clipping stage.

10. The neural amplifier according to claim 9, wherein the clipping stage (ACT)

- is connected downstream the buffer stage (BUF); and
- is configured

- to compare a differential voltage at an output of the buffer stage to a differential reference voltage;
- to output the differential reference voltage at the differential output if the differential voltage at the output of the buffer stage exceeds the differential reference voltage either in a positive or a negative direction; and
- to output, at the differential output, the differential voltage at the output of the buffer stage otherwise.

11. The neural amplifier according to one of claims 2 to 4, wherein the summation stage (SM) comprises a differential integrating amplifier (OTA1) with a pair of integrating charge stores (Cfb1a, Cfblb) in a differential feedback path of the integrating amplifier and with a pair of double sampling charge stores ($C_{CDsa}$, $C_{CDSb}$) switchably connected downstream the integrating amplifier, wherein the neural amplifier is configured

- to sample a zero input signal on the pair of double sampling charge stores ($C_{CDSa}$, $C_{CDSb}$) during a first double sampling phase, in particular by setting the at least one pair of digitally adjustable charge stores to a zero value;

and

- to provide the charges resulting from the sampled zero input signal to the buffer and activation stage (ACB) together with charges stored on the pair of integrating charge stores (Cfb1a, Cfb1b).

12. The neural amplifier according to one of the preceding claims, wherein each digitally adjustable charge store of the at least one pair of digitally adjustable charge stores comprises a first and a second charging terminal and a plurality of weighted charge stores, each having a first end connected to the first charging terminal and a second end selectively connected to the second charging terminal or to a common mode terminal depending on a digital adjustment word.

13. The neural amplifier according to one of the preceding claims, further comprising a control circuit for controlling a switched capacitor function of the neural amplifier and/or for adjusting the at least one pair of digitally adjustable charge stores.

14. An analog artificial neural network, in particular recurrent neural network, comprising a plurality of neural amplifiers according to one of the preceding claims, wherein the differential output of at least one of the neural amplifiers is connected to one of the differential inputs of the same or another one of the neural amplifiers.

15. A sensor device comprising one or more sensors and an analog artificial neural network according to the preceding claim, wherein output signals of the one or more sensors are provided to at least one of the neural amplifiers.

# Fig 1

# Fig 2

**Fig 3**

# Fig 4

# Fig 5

# Fig 6

# Fig 7

Fig 8

Fig 9

**Fig 10**

**Fig 11**

reset

$\varphi_{chop}$

$\varphi_1$

$\varphi_{1D}$

$\varphi_2$

$\varphi_{2D}$

sel

EP 3 839 833 A1

Fig 12

## Fig 13

sampling & summation

charge transfer
to buffer

## Fig 14A

φ₁ (sampling)

SMP                    SM                    BUF

## Fig 14B

φ₂ (charge transfer)

SMP                    SM                    BUF

## Fig 14C

φ₃ (buffer offset compensation)

# Fig 14D

$\varphi_4$ (charge transfer to buffer and offset sampling)

SMP          SM          BUF

# Fig 15

# Fig 16

# Fig 17

**Fig 18**

Europäisches
Patentamt

European
Patent Office

Office européen
des brevets

# EUROPEAN SEARCH REPORT

Application Number

EP 19 21 6510

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | Hung-Pin Lu ET AL: "Fully-Integrated Neural Signal Amplifier using Switched-Capacitor Technique for Direct Current Rebuffing", 2019 Symposium on Engineering, Medicine, and Biology Applications (2019 SEMBA), 1 March 2019 (2019-03-01), XP055704979, Retrieved from the Internet: URL:https://pdfs.semanticscholar.org/b90b/6ae5deb403282f16ce4fe62c7e76b7488eeb.pdf [retrieved on 2020-06-15] * abstract; figures 1-6 * * page 82, left-hand column, line 1 - page 85, left-hand column, last line * | 1-15 | INV. G06N3/063 G06N3/04 G06N3/08 |
| X Y | US 10 389 375 B1 (FICK LAURA [US] ET AL) 20 August 2019 (2019-08-20) * abstract; figures 1,2,3A-3E,7-8A * * column 1, line 1 - column 5, line 16 * * column 5, line 60 - column 26, line 35 * | 1-5,7-15 6 | |
| Y A | EP 3 300 251 A1 (AMS INT AG [CH]) 28 March 2018 (2018-03-28) * abstract; figures 1-5 * * paragraph [0001] - paragraph [0042] * * paragraph [0045] - paragraph [0062] * * paragraph [0064] * | 6 1-5,7-15 | TECHNICAL FIELDS SEARCHED (IPC) G06G G06N H03F G11C |
| A | WO 2019/011749 A1 (AMS INT AG [CH]) 17 January 2019 (2019-01-17) * abstract; figures 3-4,6 * * page 1, line 1 - page 7, line 5 * * page 7, line 26 - page 14, last line * | 1-15 | |

-/--

The present search report has been drawn up for all claims

| Place of search | Date of completion of the search | Examiner |
|---|---|---|
| The Hague | 17 June 2020 | Totir, Felix |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

# EUROPEAN SEARCH REPORT

Application Number

EP 19 21 6510

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 95/31043 A2 (PHILIPS ELECTRONICS NV [NL]; PHILIPS NORDEN AB [SE]) 16 November 1995 (1995-11-16) * abstract; figures 1-2,7 * * page 1, line 1 - page 4, line 11 * * page 4, line 30 - page 7, line 20 * * page 9, line 16 - page 11, last line * ----- | 1-15 | |

TECHNICAL FIELDS
SEARCHED     (IPC)

The present search report has been drawn up for all claims

| Place of search | Date of completion of the search | Examiner |
|---|---|---|
| The Hague | 17 June 2020 | Totir, Felix |

page 2 of 2

**ANNEX TO THE EUROPEAN SEARCH REPORT
ON EUROPEAN PATENT APPLICATION NO.**

EP 19 21 6510

This annex lists the patent family members relating to the patent documents cited in the above-mentioned European search report.
The members are as contained in the European Patent Office EDP file on
The European Patent Office is in no way liable for these particulars which are merely given for the purpose of information.

17-06-2020

| Patent document cited in search report | | | Publication date | Patent family member(s) | | | Publication date |
|---|---|---|---|---|---|---|---|
| US 10389375 | B1 | | 20-08-2019 | TW | 201939270 | A | 01-10-2019 |
| | | | | US | 10389375 | B1 | 20-08-2019 |
| | | | | US | 2019326921 | A1 | 24-10-2019 |
| | | | | US | 2020083897 | A1 | 12-03-2020 |
| | | | | WO | 2019182730 | A1 | 26-09-2019 |
| EP 3300251 | A1 | | 28-03-2018 | CN | 109792233 | A | 21-05-2019 |
| | | | | EP | 3300251 | A1 | 28-03-2018 |
| | | | | US | 2019363682 | A1 | 28-11-2019 |
| | | | | WO | 2018059796 | A1 | 05-04-2018 |
| WO 2019011749 | A1 | | 17-01-2019 | CN | 110870206 | A | 06-03-2020 |
| | | | | EP | 3429083 | A1 | 16-01-2019 |
| | | | | TW | 201918035 | A | 01-05-2019 |
| | | | | WO | 2019011749 | A1 | 17-01-2019 |
| WO 9531043 | A2 | | 16-11-1995 | CA | 2166555 | A1 | 16-11-1995 |
| | | | | CN | 1128588 | A | 07-08-1996 |
| | | | | DE | 69501381 | T2 | 25-06-1998 |
| | | | | EP | 0707759 | A1 | 24-04-1996 |
| | | | | JP | H08512421 | A | 24-12-1996 |
| | | | | TW | 313703 | B | 21-08-1997 |
| | | | | US | 5530275 | A | 25-06-1996 |
| | | | | WO | 9531043 | A2 | 16-11-1995 |

EPO FORM P0459

For more details about this annex : see Official Journal of the European Patent Office, No. 12/82